# EUROPEAN PATENT SPECIFICATION

(11) **EP 3 315 552 B1**
(45) Date of publication and mention of the grant of the patent: **01.03.2023**
(21) Application number: 16817676.6
(22) Date of filing: 08.06.2016
(51) Int. Cl.: C08L 53/02, B32B 15/08, B32B 27/28, C08F 2/44, C08J 3/24, H05K 3/38, C08C 19/25, C08F 8/04, C08F 287/00

(54) **RESIN COMPOSITION, RESIN LAMINATE AND RESIN LAMINATED METALLIC FOIL**
HARZZUSAMMENSETZUNG, HARZLAMINAT UND HARZLAMINIERTE METALLFOLIE
COMPOSITION DE RÉSINE, STRATIFIÉ DE RÉSINE ET FEUILLE MÉTALLIQUE À STRATIFIÉ DE RÉSINE

(30) Priority: 29.06.2015 JP 2015130456
(43) Date of publication of application: 02.05.2018
(73) Proprietor: Zeon Corporation, Tokyo 100-8246 (JP)
(72) Inventor: CHIBA Daido, Tokyo 100-8246 (JP); ISHIGURO Atsushi, Tokyo 100-8246 (JP); KOHARA Teiji, Tokyo 100-8246 (JP)
(74) Representative: Maiwald GmbH
(86) International application number: PCT/JP2016/067118
(87) International publication number: WO 2017/002567

(56) References cited:
- EP-A1- 3 117 990
- WO-A1-03/008466
- WO-A1-2014/133003
- JP-A- H0 563 356
- JP-A- 2006 328 410

## Description

### Technical Field

The present invention relates to a resin composition prepared by blending a crosslinking aid into a particular modified hydrogenated block copolymer, a resin laminate prepared by laminating the resin composition and a polyimide-based resin film, and a resin laminated metallic foil prepared by laminating a metallic foil on at least one side of the polyimide-based resin film through a layer including the resin composition.

### Background Art

A flexible printed board is an important member as an internal wiring or a component mounting board for an apparatus. As the flexible printed board, a two-layer CCL (Copper Clad Laminate) in which an insulating film typified by a polyimide film and a copper foil are directly adhered with each other, a three-layer CCL in which an insulating film and a copper foil are adhered with each other through an adhesive, and the like, are known. Since the two-layer CCL does not involve an adhesive, it is excellent in reliability at high temperature, but its production is not necessarily easy because a process of applying, drying and thermally imidizing a polyamic acid solution which is a precursor of polyimide on a copper foil, and other processes are required. On the other hand, since the three-layer CCL is laminated by adhering an insulating film such as a polyimide film with the copper foil through an adhesive, it is easy to industrially manufacture, with low cost, and excellent in adhesiveness between the insulating film and the copper foil. Consequently, the three-layer CCL is mainly used for general purpose.

Properties such as adhesiveness, electrical insulation, chemical resistance and solder heat resistance are required for the adhesive used for manufacturing the three-layer CCL. As adhesives meeting these requirements, polyamide/epoxy-based, polyester/epoxy-based, phenol/butyral-based, nitrile rubber/epoxy-based, acryl-based, urethane-based adhesives and the like are known.

Meanwhile, in relation to electronic devices, miniaturization, thinning and weight reducing have furthermore progressed, and densification of printed boards has been increasingly required in recent years. Additionally, in a printed board corresponding to these electronic devices, copper foils with low surface roughness, such as a low-profile copper foil with reduced unevenness on a matte surface of an electrolytic copper foil and a rolled copper foil with low surface roughness, have been used in order to reduce transmission loss.

However, in a copper foil with low surface roughness, adhesiveness with a resin substrate is poor, and adhesiveness in a fine circuit is insufficient, resulting in an obstacle to densification.

As one method for improving adhesiveness of a copper foil with low surface roughness, a large number of methods for applying a silane coupling agent on a surface of the copper foil have been proposed (e.g. Patent Literatures 1 to 4) . Further, a method for treating a surface of a copper foil with a metal alcoholate or the like as pretreatment (Patent Literature 5), a method of coating a joining face between a surface of a copper foil and a substrate with a polysiloxane film (Patent Literature 6) and the like have been proposed in order to improve a reactivity of a copper foil with a silane coupling agent.

However, although the adhesive properties for environmental resistance such as moisture resistance and heat resistance were improved by these methods, the initial adhesion strength itself could not sufficiently compensate the loss of the anchor effect due to roughening treatment of the electrolytic copper foil.

In addition, for a flexible printed board, in order to strongly adhere a copper foil with low surface roughness with a polyimide-based film through an adhesive, a method for treating a surface of a copper foil with an aminosilane coupling agent (Patent Literature 7) and the like is required in a case of adhesion through a polyamide/epoxy-based adhesive.

In relation to the present invention, Patent Literature 8 discloses that a modified hydrogenated block copolymer prepared by introducing an alkoxysilyl group into a hydrogenated block copolymer can be used for a sealant for a solar cell, because it has adhesiveness to glass and metals and is also excellent in electrical insulation.

### Citation List

### Patent Literature

PTL 1: JP-B-S60-15654
PTL 2: JP-B-H2-19994
PTL 3: JP-A-S63-183178
PTL 4: JP-A-H2-26097
PTL 5: JP-A-H5-230667
PTL 6: JP-A-H2-307294
PTL 7: JP-A-2003-298230
PTL 8: WO 2012/043708 brochure (US 2013244367 A1)

### Summary of Invention

### Technical Problem

The present invention has been made in view of the above circumstances, and the object of the present invention is to provide a novel resin composition excellent in adhesiveness to a polyimide-based resin film and a metallic foil with low surface roughness and excellent in electrical insulation, a resin laminate prepared by laminating the resin composition and a polyimide-based resin film, and a resin laminated metallic foil in which the polyimide-based resin film and a metallic foil with a low surface roughness are laminated by using the resin composition as an adhesive.

### Solution to Problem

As a result of intensive studies in order to achieve the above objects, the present inventors found that a particular modified hydrogenated block copolymer [E] prepared by introducing an alkoxysilyl group into a particular hydrogenated block copolymer [D] specifically showed strong adhesiveness to a polyimide-based resin film among various resin films and also showed strong adhesiveness to a copper foil with low surface roughness, and completed the present invention on the basis of these findings.

Thus, one aspect of the invention provides a resin composition, a resin laminate and a resin laminated metallic foil of the following (1) to (3) .
(1) A resin composition comprising:
   a modified hydrogenated block copolymer [E] prepared by introducing an alkoxysilyl group into a hydrogenated block copolymer [D],
   and a crosslinking aid;
   wherein the hydrogenated block copolymer [D] is obtained by hydrogenating 90% or more of carbon-carbon unsaturated bonds on a main chain and side chains and carbon-carbon unsaturated bonds on aromatic rings in a block copolymer [C] which includes at least two polymer blocks [A] mainly containing a structural unit derived from an aromatic vinyl compound and at least one polymer block [B] mainly containing a structural unit derived from an acyclic conjugated diene compound,
      wherein a ratio of wA to wB (wA:wB) is 30:70 to 60:40 when a weight fraction of all the polymer blocks [A] accounting for all the block copolymers is defined as wA and a weight fraction of all the polymer blocks [B] accounting for all the block copolymers is defined as wB.
(2) The resin composition according to (1), wherein a content of the crosslinking aid is 0.1 to 15 parts by weight based on 100 parts by weight of the modified hydrogenated block copolymer [E].
(3) A resin laminate prepared by laminating a layer including the resin composition according to (1) or (2) on at least one side of a polyimide-based resin film.
(4) A resin laminated metallic foil prepared by laminating a metallic foil on at least one side of the polyimide-based resin film through the layer including the resin composition according to (1) or (2).
(5) The resin laminated metallic foil according to (4), wherein a surface roughness of the metallic foil is 3.0 µm or lower at the maximum height roughness Rz.

### Advantageous Effects of Invention

One aspect of the invention provides a novel resin composition excellent in adhesiveness to a polyimide-based resin film and a metallic foil with low surface roughness and excellent in electrical insulation, and a resin laminated copper foil in which the polyimide-based resin film and a metallic foil with a low surface roughness are laminated by using the resin composition as an adhesive.

The resin laminated metallic foil according to one embodiment of the invention is suitably used for manufacturing a high-density flexible printed board.

### Description of Embodiments

### 1. Resin composition

The resin composition according to one embodiment of the invention (hereinafter referred to as "resin composition [F]" in some cases) contains a particular modified hydrogenated block copolymer [E] and a crosslinking aid.

### (Modified hydrogenated block copolymer [E])

The modified hydrogenated block copolymer [E] used in the present invention is obtained by introducing the alkoxysilyl group into the hydrogenated block copolymer [D] prepared by hydrogenating 90% or more of the carbon-carbon unsaturated bonds on the main chain and the side chains and the carbon-carbon unsaturated bonds on the aromatic ring in the block copolymer [C] including at least two polymer blocks [A] mainly containing the structural unit derived from the aromatic vinyl compound and at least one polymer block [B] mainly containing the structural unit derived from the acyclic conjugated diene compound.

### (Block copolymer [C])

The block copolymer [C] is a block copolymer including at least two polymer blocks [A] mainly containing the structural unit derived from the aromatic vinyl compound and at least one polymer block [B] mainly containing the structural unit derived from the acyclic conjugated diene compound.

The polymer block [A] mainly contains the structural unit derived from the aromatic vinyl compound.

The content of the structural unit derived from the aromatic vinyl compound in the polymer block [A] is normally 95 wt% or more, preferably 97 wt% or more, and more preferably 99 wt% or more based on all the structural units in the polymer block [A].

If the amount of the structural unit derived from the aromatic vinyl compound in the polymer block [A] is too small, the heat resistance of the resin composition [F] possibly decreases.

The polymer block [A] may contain components other than the structural unit derived from the aromatic vinyl compound. Examples of the other components include a structural unit derived from an acyclic conjugated diene and/or a structural unit derived from other vinyl compounds. Its content is normally 5 wt% or less, preferably 3 wt% or less, and more preferably 1 wt% or less based on all the structural units in the polymer block [A].

Examples of the aromatic vinyl compound include styrene; styrenes having an alkyl group as a substituent, such as α-methylstyrene, 2-methylstyrene, 3-methylstyrene, 4-methylstyrene, 2,4-diisopropylstyrene, 2,4-dimethylstyrene, 4-t-butylstyrene and 5-t-butyl-2-methylstyrene; styrenes having a halogen atom as a substituent, such as 4-monochlorostyrene, dichlorostyrene and 4-monofluorostyrene; styrenes having an aryl group as a substituent, such as 4-phenylstyrene; styrenes having an alkoxy group as a substituent, such as 4-methoxystyrene and 3,5-dimethoxystyrene; and the like. Above all, styrenes containing no polar group such as the styrenes; the styrenes having an alkyl group as a substituent; the styrenes having an aryl group as a substituent are preferred from the viewpoint of hygroscopicity, and styrene is particularly preferred because it is industrially available with ease.

Examples of the acyclic conjugated diene and other vinyl compounds include the same compounds as the acyclic conjugated diene and other vinyl compounds, which are a structural unit of the polymer block [B] described below.

The polymer block [B] mainly contains a structural unit derived from an acyclic conjugated diene compound. The content of the structural unit derived from the acyclic conjugated diene compound in the polymer block [B] is normally 80 wt% or more, preferably 90 wt% or more, and more preferably 95 wt% or more based on all the structural units in the polymer block [B].

The polymer block [B] may contain a component other than the structural unit derived from the acyclic conjugated diene compound. Examples of the other component include a structural unit derived from an aromatic vinyl compound and/or a structural unit derived from other vinyl compounds, and the like. Its content is normally 20 wt% or less, preferably 10 wt% or less, and more preferably 5 wt% or less based on all the structural units in the polymer block [B].

When the content of the structural unit derived from the acyclic conjugated diene compound is within the above range, the resin composition [F] is excellent in thermal shock resistance and adhesiveness at low temperature.

The acyclic conjugated diene compound is not particularly limited as long as it is a conjugated diene compound having a chain structure. Above all, the acyclic conjugated diene-based compound containing no polar group, such as 1,3-butadiene, isoprene, 2,3-dimethyl-1,3-butadiene and 1,3-pentadiene is preferred from the viewpoint of hygroscopicity, and the 1,3-butadiene and isoprene are particularly preferred because they are industrially available with ease.

Examples of other vinyl-based compounds include an acyclic vinyl compound, a cyclic vinyl compound, an unsaturated cyclic acid anhydride, an unsaturated imide compound and the like. These compounds may have a substituent such as a nitrile group, an alkoxycarbonyl group, a hydroxycarbonyl group and a halogen atom. Above all, a compound containing no polar group such as: an acyclic olefin having 2 to 20 carbon atoms such as ethylene, propylene, 1-butene, 1-pentene, 1-hexene, 1-heptene, 1-octene, 1-nonene, 1-decene, 1-dodecene, 1-eicosene, 4-methyl-1-pentene and 4,6-dimethyl-1-heptene; a cycloolefin having 5 to 20 carbon atoms such as vinylcyclohexane and norbornene; and a cyclodiene compound such as 1,3-cyclohexadiene and norbornadiene, is preferred from the viewpoint of hygroscopicity.

The block copolymer [C] is a copolymer in which, when a weight fraction of all the polymer blocks [A] accounting for all the block copolymers [C] is defined as wA and a weight fraction of all the polymer blocks [B] accounting for all the block copolymers [C] is defined as wB, the ratio of wA to wB (wA:wB) is 30:70 to 60:40, preferably 35:65 to 55:45, and more preferably 40:60 to 50:50. When the ratio (wA:wB) is within this range, the resin composition [F] having adhesiveness and adequate heat resistance can be obtained.

In the block copolymer [C], the number of the polymer blocks [A] is normally 3 or less, and preferably 2, and the number of the polymer blocks [B] is normally 2 or less, and preferably 1.

Each of the plural polymer blocks [A] may be the same as or different from each other. Further, when there is a plurality of polymer blocks [B], each of the polymer blocks [B] may be the same as or different from each other.

Although the block form of the block copolymer [C] may be a chain-type block or a radial-type block, the form of the chain-type block is preferred because of excellent mechanical strength. The most preferred form for the block copolymer [C] is a [A]-[B]-[A]-type triblock copolymer in which the polymer blocks [A] bind to both ends of the polymer block [B].

The molecular weight of the block copolymer [C] refers to a weight average molecular weight (Mw) in terms of polystyrene determined by gel permeation chromatography (GPC) using tetrahydrofuran (THF) as a solvent, and is normally 40,000 to 200,000, preferably 45,000 to 150,000, and more preferably 50,000 to 100,000. In addition, the molecular weight distribution (Mw/Mn) of the block copolymer [C] is preferably 3 or less, more preferably 2 or less, and particularly preferably 1.5 or less. When the Mw and the Mw/Mn are within the above range, the resin composition [F] having improved heat resistance and mechanical strength can be obtained.

A method for producing the block copolymer [C] is not particularly limited, and a known method can be adopted. Examples of the method include e.g. a method in which a monomer mixture (a) mainly containing an aromatic vinyl compound and a monomer mixture (b) mainly containing an acyclic conjugated diene compound are alternately polymerized by a process such as living anion polymerization; a method in which the monomer mixture (a) mainly containing an aromatic vinyl compound and the monomer mixture (b) mainly containing an acyclic conjugated diene compound are sequentially polymerized, and then the ends of the polymer blocks [B] are coupled with each other by a known coupling agent; and the like.

The content of the aromatic vinyl compound in the monomer mixture (a) is normally 95 wt% or more, preferably 97 wt% or more, and more preferably 99 wt% or more. In addition, the content of the acyclic conjugated diene compound in the monomer mixture (b) is normally 80 wt% or more, preferably 90 wt% or more, and more preferably 95 wt% or more.

### (Hydrogenated block copolymer [D])

The hydrogenated block copolymer [D] is a polymer obtained by hydrogenating the carbon-carbon unsaturated bonds on the main chain and the side chains and the carbon-carbon unsaturated bonds on the aromatic ring in the block copolymer [C].

Its hydrogenation ratio is normally 90% or higher, preferably 97% or higher, and more preferably 99% or higher. The higher the hydrogenation ratio is, the better the heat resistance and durability of the resin composition [F] are.

The hydrogenation ratio of the hydrogenated block copolymer [D] can be determined by ¹H-NMR measurement of the hydrogenated block copolymer [D].

The molecular weight of the hydrogenated block copolymer [D] refers to a weight average molecular weight (Mw) in terms of polystyrene determined by GPC using THF as a solvent, and is normally 40,000 to 200,000, preferably 45,000 to 150,000, and more preferably 50,000 to 100,000. In addition, the molecular weight distribution (Mw/Mn) of the hydrogenated block copolymer [D] is preferably 3 or less, more preferably 2 or less, and particularly preferably 1.5 or less. When the Mw and the Mw/Mn are within the above range, the resin composition [F] having better heat resistance and mechanical strength can be obtained.

The hydrogenation method, the reaction form and the like of the unsaturated bond are not particularly limited and may comply with a known method, but a hydrogenation method in which the hydrogenation ratio can be increased and the polymer chain-cleaving reaction is reduced, is preferred. Examples of such a hydrogenation method include e.g. methods described in WO2011/096389 brochure, WO2012/043708 brochure and the like.

After completion of the hydrogenation reaction, the hydrogenation catalyst, or the hydrogenation catalyst and the polymerization catalyst are removed from the reaction solution, and then the hydrogenated block copolymer [D] can be isolated from the resulting solution. The form of the isolated hydrogenated block copolymer [D] is not limited, but the copolymer is normally formed in a form of pellet, into which subsequently additives can be blended and an alkoxysilyl group can be introduced.

### (Modified hydrogenated block copolymer [E])

The modified hydrogenated block copolymer [E] is prepared by introducing an alkoxysilyl group into the hydrogenated block copolymer [D].

The alkoxysilyl group is introduced into the hydrogenated block copolymer [D], so that strong adhesiveness to a copper foil and a polyimide-based resin film can be provided.

Examples of the alkoxysilyl group include a tri(alkoxy having 1 to 6 carbon atoms) silyl group such as a trimethoxysilyl group and a triethoxysilyl group; an (alkyl having 1 to 20 carbon atoms) di(alkoxy having 1 to 6 carbon atoms) silyl group such as a methyldimethoxysilyl group, a methyldiethoxysilyl group, an ethyldimethoxysilyl group, an ethyldiethoxysilyl group, a propyldimethoxysilyl group and a propyldiethoxysilyl group; an (aryl) di (alkoxy having 1 to 6 carbon atoms) silyl group such as a phenyldimethoxysilyl group and a phenyldiethoxysilyl group; and the like. In addition, the alkoxysilyl group may be bound to the hydrogenated block copolymer [D] via a divalent organic group such as an alkylene group having 1 to 20 carbon atoms and an alkyleneoxycarbonylalkylene group having 2 to 20 carbon atoms.

The amount of the alkoxysilyl group introduced into the hydrogenated block copolymer [D] is normally 0.1 to 10 parts by weight, preferably from 0.2 to 5 parts by weight, and more preferably 0.5 to 3 parts by weight based on 100 parts by weight of the hydrogenated block copolymer [D] . If the amount of the introduced alkoxysilyl group is too large, crosslinking of the alkoxysilyl groups decomposed by a tiny amount of water or the like proceeds during preservation of the resulting modified hydrogenated block copolymer [E] progresses, and the adhesiveness to the copper foil and the polyimide-based resin film possibly decreases due to gelation and lowered flowability during melt-forming. In addition, if the amount of the introduced alkoxysilyl group is too small, the adhesiveness to the copper foil and the polyimide-based resin film possibly decreases.

The modified hydrogenated block copolymer [E] can be produced in accordance with a known method. Examples of the method include methods described in e.g. WO 2012/043708 brochure, WO 2013/176258 brochure and the like.

More specifically, it can be exemplified by a method of reacting an ethylenically unsaturated silane compound with the hydrogenated block copolymer [D] in the presence of an organic peroxide.

The ethylenically unsaturated silane compound to be used is not particularly limited as long as it can graft-polymerize with the hydrogenated block copolymer [D] to introduce an alkoxysilyl group into the hydrogenated block copolymer [D].

For example, a vinyltrialkoxysilane compound such as vinyltrimethoxysilane and vinyltriethoxysilane; an allyltrialkoxysilane compound such as allyltrimethoxysilane and allyltriethoxysilane; a dialkoxyalkylvinylsilane compound such as dimethoxymethylvinylsilane and diethoxymethylvinylsilane; a p-styryltrialkoxysilane compound such as p-styryltrimethoxysilane and p-styryltriethoxysilane; a (meth)acryloxyalkyltrialkoxysilane compound such as 3-acryloxypropyltrimethoxysilane, 3-acryloxypropyltriethoxysilane, 3-methacryloxypropyltrimethoxysilane and 3-methacryloxypropyltriethoxysilane; a (meth)acryloxyalkylalkyldialkoxysilane compound such as 3-methacryloxypropylmethyldimethoxysilane and 3-methacryloxypropylmethyldiethoxysilane; and the like are preferably used. These ethylenically unsaturated silane compounds may be used either alone or in combination.

The ethylenically unsaturated silane compound is normally used in an amount of 0.1 to 10 parts by weight, preferably 0.2 to 5 parts by weight, and more preferably 0.5 to 3 parts by weight based on 100 parts by weight of the hydrogenated block copolymer [D].

As a peroxide, one having a one-minute half-life temperature of 170 to 190°C is preferably used. For example, t-butylcumyl peroxide, dicumyl peroxide, di-t-hexyl peroxide, 2,5-dimethyl-2,5-di(t-butylperoxy)hexane, di-t-butyl peroxide, di(2-t-butylperoxyisopropyl)benzene and the like are preferably used. These peroxides may be used either alone or in combination. The peroxide is normally used in an amount of 0.05 to 2 parts by weight, preferably 0.1 to 1 part by weight, and more preferably 0.2 to 0.5 part by weight based on 100 parts by weight of the hydrogenated block copolymer [D].

The method of reacting the hydrogenated block copolymer [D] with the ethylenically unsaturated silane compound in the presence of a peroxide is not particularly limited. For example, an alkoxysilyl group can be introduced into the hydrogenated block copolymer [D], by kneading them in a twin-screw kneader at a desired temperature for a desired time. The temperature required for kneading with the twin-screw kneader is normally 180 to 220°C, preferably 185 to 210°C, and more preferably 190 to 200°C. The time required for heating and kneading is normally around 0.1 to 10 minutes, preferably around 0.2 to 5 minutes, and more preferably around 0.3 to 2 minutes. Kneading and extrusion may be continuously conducted so that the temperature and the detention time are within the above range. The form of the resulting modified hydrogenated block copolymer [E] is not limited, but the copolymer is normally formed into a form of pellet, into which subsequently additives such as a crosslinking aid can be blended.

The molecular weight of the modified hydrogenated block copolymer [E] is substantially the same as the molecular weight of the hydrogenated block copolymer [D] used as a raw material, because the alkoxysilyl group is introduced in a small amount. On the other hand, since the modified hydrogenated block copolymer [E] is reacted with the ethylenically unsaturated silane compound in the presence of a peroxide, the crosslinking reaction and the cleavage reaction of the polymers concurrently occur, and the molecular weight distribution value of the modified hydrogenated block copolymer [E] becomes higher.

The molecular weight of the modified hydrogenated block copolymer [E] refers to a weight average molecular weight (Mw) in terms of polystyrene determined by GPC using THF as a solvent, and is normally 40, 000 to 200,000, preferably 50,000 to 150,000, and more preferably 60,000 to 100,000. In addition, its molecular weight distribution (Mw/Mn) is preferably 3.5 or less, more preferably 2.5 or less, and particularly preferably 2.0 or less. When the Mw and the Mw/Mn are within the above range, the heat resistance and the mechanical strength of the modified hydrogenated block copolymer [E] can be maintained.

### (Resin composition [F])

The resin composition [F] according to one embodiment of the invention contains the modified hydrogenated block copolymer [E] and a crosslinking aid.

By blending a crosslinking aid into the modified hydrogenated block copolymer [E], the modified hydrogenated block copolymer [E] can be crosslinked with treatments such as heating and irradiation of a high energy irradiation to infusibilize it and improve its heat resistance.

### (Crosslinking aid)

Examples of the crosslinking aid to be used include a polyfunctional vinyl compound such as triallyl isocyanurate, triallyl cyanurate, diallyl phthalate, diallyl fumarate, diallyl maleate, trimethyl trimellitate, triallyl mellitate, diallyl mellitate, divinyl benzene, vinyl butyrate or vinyl stearate;
a polyfunctional methacrylate compound such as ethyleneglycol dimethacrylate, diethyleneglycol dimethacrylate, triethyleneglycol dimethacrylate, tetraethyleneglycol dimethacrylate, polyethyleneglycol dimethacrylate with an ethyleneglycol repeating number of 9 to 14, trimethylolpropane trimethacrylate, allyl methacrylate, 2-methyl-1,8-octanediol dimethacrylate or 1,9-nonanediol dimethacrylate;
a polyfunctional acrylate compound such as polyethyleneglycol diacrylate, 1,6-hexanediol diacrylate, neopentylglycol diacrylate, propyleneglycol diacrylate; or the like.

These crosslinking aids may be used either alone or in combination.

The crosslinking aid is normally used in an amount of 0.1 to 15 parts by weight, preferably 0.2 to 10 parts by weight, and more preferably 0.5 to 5 parts by weight based on 100 parts by weight of the modified hydrogenated block copolymer [E] . If the amount of the crosslinking aid to be used is too small, the effect of improving the heat resistance of the resin composition [F] is slight, and if the amount is too large, the electrical insulation possibly decreases.

The method of blending the crosslinking aid into the modified hydrogenated block copolymer [E] is not particularly limited. Examples of the method include e.g. a method in which after adding the modified hydrogenated block copolymer [E] and a crosslinking aid, the mixture is melt-kneaded using a twin-screw kneader, an extruder or the like to homogeneously mix them; a method in which the modified hydrogenated block copolymer [E] is dissolved in an organic solvent such as toluene and xylene, and a crosslinking aid is added to this solution and homogeneously mixed; and the like.

### (Other additives)

An organic peroxide, an antioxidant, a flame retardant and the like can be blended into the resin composition [F] in order to improve mechanical properties and chemical properties.

For the organic peroxide to be used, an initial decomposition temperature is a temperature for adhering the resin composition [F] to a polyimide-based resin film or a copper foil or higher, normally 100°C or higher, preferably 120°C or higher, and more preferably 140°C or higher. Specifically, a temperature at which the half-life (time required for decomposing 50%) is 1 hour, is normally 100°C or higher, preferably 120°C or higher, and more preferably 140°C or higher.

The crosslinking during heating can be promoted by blending an organic peroxide into the resin composition [F].

Specific examples of such organic peroxides include 1,1-di(t-butylperoxy)-2-methylcyclohexane, 1,1-di(t-butylperoxy)cyclohexane, 2,5-dimethyl-2,5-di(benzoylperoxy)hexane, 2,2-di(t-butylperoxy)butane, n-butyl-4,4-di(t-butylperoxy)valerate, dicumyl peroxide, di-t-hexyl peroxide, t-butylcumyl peroxide, 2,5-dimethyl-2,5-di(t-butylperoxy)hexane, di-t-butyl peroxide, p-menthane hydroperoxide, and the like. These organic peroxides may be used either alone or in combination.

The organic peroxide is normally blended in an amount of 5 parts by weight or less, preferably 4 parts by weight or less, and more preferably 3 parts by weight or less based on 100 parts by weight of the modified hydrogenated block copolymer [E].

If the amount of the organic peroxide to be used is too large, there is a possibility that the storage stability of the resin composition [F] decreases and the mechanical strength of the resin composition [F] after heat crosslinking decreases.

As a method for blending an organic peroxide into the resin composition [F], a method in which the modified hydrogenated block copolymer [E] and a crosslinking aid are dissolved in an organic solvent, an organic peroxide is added to this solution, and homogeneously blended by dissolving it at a temperature at which the organic peroxide is hardly decomposed, is preferred.

Further, in the resin composition [F], an antioxidant, a flame retardant or the like can be blended to improve the long-term thermal stability and provide flame retardance.

These additives are normally blended in an amount of 10 parts by weight or less, preferably 5 parts by weight or less, and more preferably 3 parts by weight or less based on 100 parts by weight of the modified hydrogenated block copolymer [E].

Examples of the antioxidant include a phenol-based antioxidant, a phosphorus-based antioxidant, a sulfur-based antioxidant, and the like.

Examples of the phenol-based antioxidant include 3,5-di-t-butyl-4-hydroxytoluene, dibutylhydroxytoluene, 2,2'-methylenebis(6-t-butyl-4-methylphenol), 4,4'-butylidenebis(3-t-butyl-3-methylphenol), 4,4'-thiobis(6-t-butyl-3-methylphenol), α-tocopherol, 2,2,4-trimethyl-6-hydroxy-7-t-butylchroman, tetrakis[methylene-3-(3',5'-di-t-butyl-4'-hydroxyphenyl)pro pionate]methane, {pentaerythritol tetrakis[3-(3,5-di-t-butyl-4-hydroxyphenyl)propionate]}, and the like.

Examples of the phosphorus-based antioxidant include distearylpentaerythritol diphosphite, bis(2,4-di-t-butylphenyl)pentaerythritol diphosphite, tris(2,4-di-t-butylphenyl)phosphite, tetrakis(2,4-di-t-butylphenyl)-4,4'-biphenyl diphosphite, trinonylphenyl phosphite, and the like.

Examples of the sulfur-based antioxidant include distearyl thiodipropionate, dilauryl thiodipropionate, and the like.

Examples of the flame retardant include halogen compounds normally used for flame retardation of resins and the like, and inorganic flame retardants such as antimony compounds.

Examples of the halogen compound include e.g. tetrabromobisphenol A, brominated epoxy type, halogenated polycarbonate and the like. Examples of the inorganic flame retardant include antimony trioxide, antimony tetraoxide, antimony pentoxide, sodium pyroantimonate, aluminum hydroxide and the like.

A method of blending an antioxidant, a flame retardant and the like into the resin composition [F] is not particularly limited. Examples of the method include e.g. a method of melt-kneading the resin composition and a method of blending the resin composition in a solution state, as in the case of blending the crosslinking aid.

In a solid form such as a pellet form and a film form, or in a solution form dissolved or dispersed in an organic solvent, the resin composition [F] produced as described above can be used for adhesion of a polyimide-based resin film or a copper foil, or the like.

When the resin composition [F] is used as an adhesive for a polyimide-based resin film or a copper foil, the resin composition [F] is adhered to a substrate by thermally press-bonding before crosslinked by heating or irradiation with high energy irradiation to be infusibilized, and then crosslinked by further heating or irradiation with high energy irradiation to provide heat resistance.

The temperature for adhering the resin composition [F] to the polyimide-based resin film or the copper foil is normally 100 to 250°C, preferably 120 to 230°C, and more preferably 140 to 200°C. When the temperature for adhesion is lower than 100°C, strong adhesiveness cannot be obtained, and when it is higher than 250°C, the mechanical strength of the resin composition [F] possibly decreases.

Examples of the method for improving the heat resistance of the resin composition [F] after adhering the resin composition [F] to the polyimide-based resin film or the copper foil include a method using heating, and a method using irradiation with high energy irradiation. In the method using heating, heat treatment is normally effected at 130 to 200°C, preferably 140 to 180°C, and more preferably 140 to 160°C. In the method using irradiation with high energy irradiation such as gamma ray and electron beam, the dose of irradiation is normally 25 to 500 kGy, preferably 50 to 400 kGy, and more preferably 100 to 300 kGy. If the dose of irradiation is below this range, the effect of improving the heat resistance of the resin composition [F] possibly decreases, and if it is above this range, economic efficiency possibly becomes inferior.

### 2. Resin laminate

The resin laminate according to one embodiment of the invention (hereinafter referred to as "resin laminate [G]" in some cases) is prepared by laminating a layer including a resin composition [F] on at least one side of a polyimide-based resin film.

The polyimide-based resin film used in the present invention is a film including a polymer having an imide structure in a repeating structural unit. Its specific examples include a polyimide film, a polyamideimide film, a polyetherimide film, a bismaleimide-based resin film, and the like.

The thickness of the polyimide-based resin film is not particularly limited, but is normally 10 to 200 um, preferably 20 to 150 µm, and more preferably 30 to 100 µm. When the thickness is within this range, electrical insulation, mechanical strength, flexibility and the like are sufficient, and the polyimide-based resin film is preferred as an insulating film for a flexible printed board.

The thickness of the resin composition [F] layer laminated on the polyimide-based resin film is normally 2 to 500 um, preferably 5 to 200 µm, and more preferably 10 to 100 um. When the thickness is within this range, it is preferred because it has sufficient adhesiveness also to a roughened surface of a metallic foil and has sufficient flexibility and mechanical strength.

The resin laminate [G] prepared by laminating the resin composition [F] on the polyimide-based resin film is adhered to the metallic foil through a layer including the resin composition [F] to provide a resin laminated metallic foil advantageous for producing a high-density flexible printed board. In addition, the resin laminate [G] can also strongly adhere with a glass plate, another metallic foil such as an aluminum foil or a stainless steel foil, another polyimide-based resin film or the like through a layer including the resin composition [F] to provide a composite multilayer laminate.

### 3. Resin laminated metallic foil

The resin laminated metallic foil according to one embodiment of the invention (hereinafter referred to as "resin laminated metallic foil [H]" in some cases) is prepared by laminating a metallic foil on at least one side of a polyimide-based resin film through a layer including the resin composition [F].

Examples of the metallic foil include a copper foil, an aluminum foil, a nickel foil, a chromium foil, a gold foil, a silver foil and the like, and the copper foil is particularly preferred. As the copper foil, a rolled copper foil, a copper foil whose surface is roughened, and the like can be used. The thickness of the metallic foil to be used is not particularly limited. The thickness of the metallic foil is normally 1.5 to 70 µm.

A roughened state of the surface of the metallic foil is not particularly limited, and may be appropriately selected depending on its intended purpose. When a flexible printed board for high frequency is manufactured using the resin laminated metallic foil [H], the surface roughness of the metallic foil to be used is normally 3.0 um or lower, preferably 1.5 µm or lower, and more preferably 1.0 µm or lower, at the maximum height roughness Rz. When the maximum height roughness Rz is within this range, a flexible printed board having a small transmission loss at a high frequency region can be obtained, and furthermore there are also effects of improving the transparency of a substrate film portion after removing the metallic foil of the obtained three-layer CCL by etching, and of facilitating the positioning of the flexible printed board during assembly.

In producing the resin laminated metallic foil [H], the method for adhering the polyimide-based resin film and the metallic foil to each other using the resin composition [F] according to one embodiment of the invention is not particularly limited. Examples of the method include e.g. a method in which the resin composition [F] formed into a film form is thermally press-bonded while it is inserted between a polyimide resin film and a metallic foil; a method in which the resin composition [F] in a solution form is applied on a surface of a metallic foil and a solvent is evaporated to form a layer including the resin composition [F] on the surface of the metallic foil, and the metallic foil is thermally press-bonded to a polyimide-based resin film while facing each other through the layer including the resin composition [F]; and the like.

The specific method for strongly adhering the polyimide-based resin film and the metallic foil with each other through the layer including the resin composition [F] is exemplified by e.g. a method in which treatment is carried out using a device such as a hot press forming machine, a roll press machine and a vacuum laminator, at a temperature of normally 100 to 250°C, preferably 120 to 220°C, and more preferably 140 to 200°C, under a pressure of normally 0.05 to 2.0 MPa, preferably 0.1 to 1.0 MPa, and more preferably 0.2 to 0.8 MPa, with a time for press-bonding of normally 1 to 2,000 seconds, preferably 5 to 1,500 seconds, and more preferably 10 to 1,000 seconds.

For the resulting resin laminated metallic foil [H], the crosslinking of the resin composition [F] layer can be further progressed by treatments such as heating in an oven and irradiation with a high energy irradiation such as gamma ray and electron beam to improve the heat resistance.

The layer structure of the resin laminated metallic foil [H] according to one embodiment of the invention is not particularly limited. Examples of the layer structure include e.g. a three-layer structure like polyimide-based resin film / resin composition [F] layer / metallic foil; a five-layer structure like metallic foil / resin composition [F] layer / polyimide-based resin film / resin composition [F] layer / metallic foil; and the like.

The resin laminated metallic foil [H] according to one embodiment of the invention can be used as a material for manufacturing a flexible printed board, and can be preferably used as a material for a high-frequency flexible printed board because a polyimide-based resin film and a metallic foil can be strongly adhered with each other particularly even when a metallic foil having a low surface roughness is used.

### Examples

The present invention will be further described below by way of Examples in detail, but the present invention is not limited only to the following Examples. Note that the units "parts" and "%" refer to "parts by weight" and "wt%" respectively unless otherwise indicated.

The evaluation in Examples was carried out in accordance with the following method.

### (1) Weight average molecular weight (Mw) and molecular weight distribution (Mw/Mn)

The molecular weights of the block copolymer [C] and the hydrogenated block copolymer [D] were measured by GPC using THF as an eluent at 38°C, and determined as values expressed in terms of standard polystyrene. As a measuring apparatus, HLC8020GPC manufactured by Tosoh Corporation was used.

### (2) Hydrogenation ratio

The hydrogenation ratios of the main chain, the side chain and the aromatic ring of the hydrogenated block copolymer [D] were calculated by measuring the ¹H-NMR spectrum.

### (3) Evaluation of adhesiveness of layer including the resin composition [F] with resin film

A resin laminate sample for measuring the peel strength having a two-layer structure of film with a thickness of 300 to 400 µm including the resin composition [F] / resin film with a thickness of 50 to 200 µm, was prepared. Subsequently, the sample was cut into a size of 15 mm in width × 150 mm in length to prepare a test piece for measuring peel strength.

A part of the interface between the layer including the resin composition [F] and the resin film in this test piece was peeled off, the test piece was fixed on a tensile tester (product name: "AGS-10 KNX" manufactured by Shimadzu Corporation) so that only the resin film could be stretched, and a 180° peeling test was carried out at a peeling rate of 100 mm/min in accordance with JIS K 6854-2, to measure the peel strength.

In evaluation of adhesiveness, a case of the peel strength of 10 N/cm or higher was rated as "Good" in adhesiveness, and a case of lower than 10 N/cm was rated as "Insufficient".

### (4) Evaluation of adhesiveness of layer including the resin composition [F] with copper foil

A resin laminated copper foil having a three-layer structure of polyimide-based resin film / resin composition [F] layer / copper foil was prepared, and this sample was cut into a size of 15 mm in width × 150 mm in length to prepare a test piece for measuring peel strength.

A part of the interface between the layer including the resin composition [F] and the copper foil in this test piece was peeled off, the test piece was fixed on the same tensile tester as described above so that only the copper foil could be stretched, and the 180° peeling test was carried out at a peeling rate of 100 mm/min in accordance with JIS K 6854-2 to measure the peel strength. In evaluation of adhesiveness, a case of the peel strength of 10 N/cm or higher was rated as "Good" in adhesiveness, and a case of lower than 10 N/cm was rated as "Insufficient".

### (5) Evaluation of heat resistance

A resin laminated copper foil [H] having a three-layer structure of polyimide-based resin film / resin composition [F] layer / copper foil was prepared, and this sample was cut into a size of 100 mm in width × 200 mm in length to prepare a test piece for evaluating heat resistance.

This test piece was held in an oven at a temperature of 260°C for 60 seconds, which is the same condition as in the general reflow soldering process, and then the appearance was visually inspected for the presence or absence of abnormality.

In evaluation of heat resistance, a case where abnormalities such as deformation, peeling, foaming and expansion were not observed in appearance inspection, was rated as "Good", and a case where abnormalities were observed, was rated as "Bad".

### (6) Measurement of dielectric constant and dielectric loss tangent

A test piece of 10 mm in width × 30 mm in length × 3 mm in thickness including the resin composition [F] was prepared, and a dielectric constant and a dielectric loss tangent were measured in air at a temperature of 23°C and a frequency of 1 GHz by a cavity resonator method in accordance with ASTM D2520.

### [Production Example 1] Production of modified hydrogenated block copolymer [E₁]

### (Block copolymer [C₁])

400 parts of dehydrated cyclohexane, 25.0 parts of dehydrated styrene and 0.475 part of di-n-butyl ether were put in a reactor equipped with a stirrer whose inside had been sufficiently replaced by nitrogen, to which 0.88 part of cyclohexane solution containing 15% of n-butyllithium was added while stirring the whole content at 60°C to start polymerization, and the reaction was continued while stirring at 60°C for 60 minutes. At this time, as a result of analyzing the reaction solution by gas chromatography (GC), the polymerization conversion ratio was 99.5%.

Subsequently, 50. 0 parts of dehydrated isoprene was added to the reaction solution, and the stirring was continued at 60°C for 30 minutes. At this time, as a result of analyzing the reaction solution by GC, the polymerization conversion ratio was 99.5%.

Subsequently, 25.0 parts of dehydrated styrene was further added to the reaction solution, and stirred at 60°C for 60 minutes. At this time, as a result of analyzing the reaction solution by GC, the polymerization conversion ratio was nearly 100%. Herein, 0.5 part of isopropyl alcohol was added to terminate the reaction, to obtain a polymer solution.

The block copolymer [C₁] contained in the polymer solution had a weight average molecular weight (Mw) of 47,200, a molecular weight distribution (Mw/Mn) of 1.04, and wA:wB was 50:50.

### (Hydrogenated block copolymer [D₁])

Subsequently, the polymer solution was transferred to a pressure-resistant reactor equipped with a stirrer, to which 8.0 parts of diatomaceous earth-supported nickel catalyst (product name: "E22U", amount of nickel: 60%, manufactured by JGC Catalysts and Chemicals Ltd.) as a hydrogenation catalyst, and 100 parts of dehydrated cyclohexane were added, and mixed. The inside of the reactor was replaced by hydrogen gas, to which hydrogen was further fed while stirring the solution, and hydrogenation reaction was continued at a temperature of 190°C under a pressure of 4.5 MPa for 6 hours.

The hydrogenated block copolymer [D₁] contained in the reaction solution obtained by hydrogenation reaction had a weight average molecular weight (Mw) of 49,900, and a molecular weight distribution (Mw/Mn) of 1.06.

After completion of the hydrogenation reaction, the reaction solution was filtered to remove the hydrogenation catalyst, and then 2.0 parts of xylene solution prepared by dissolving 0.1 part of pentaerythrityl tetrakis[3-(3,5-di-t-butyl-4-hydroxyphenyl)propionate] (product name: "Songnox 1010", manufactured by Matsubarasangyo K.K.) as a phenol-based antioxidant was added and dissolved.

Subsequently, the above solution was filtered through a metal fiber filter (pore diameter: 0.4 um, manufactured by NICHIDAI CO., LTD.) to remove fine solid contents, and then cyclohexane, xylene and other volatile components as solvents were removed from the solution using a cylindrical concentration dryer (product name: "Kontro", manufactured by Hitachi, Ltd.) at a temperature of 260°C under a pressure of 0.001 MPa or lower. The molten polymer was extruded from the die in a strand form, cooled, and then 95 parts of pellet of the hydrogenated block copolymer [D₁] was produced by a pelletizer.

The resulting pelletized hydrogenated block copolymer [D₁] had a weight average molecular weight (Mw) of 49,500, a molecular weight distribution (Mw/Mn) of 1.10, and a hydrogenation ratio of nearly 100%.

### (Modified hydrogenated block copolymer [E₁])

To 100 parts of the resulting pellet of the hydrogenated block copolymer [D₁], 2.0 parts of vinyltrimethoxysilane and 0.2 part of 2,5-dimethyl-2,5-di(t-butylperoxy)hexane (product name: "PERHEXA (registered trademark) 25B" manufactured by NOF CORPORATION) were added. This mixture was kneaded using a twin-screw extruder at a resin temperature of 200°C with a detention time of 60 to 70 seconds, extruded in a strand form, air-cooled, and then cut by a pelletizer to obtain 96 parts of pellet of the modified hydrogenated block copolymer [E₁] having an alkoxysilyl group.

10 parts of the resulting pellet of the modified hydrogenated block copolymer [E₁] was dissolved in 100 parts of cyclohexane, then poured into 400 parts of dehydrated methanol to coagulate the modified hydrogenated block copolymer [E₁], and the coagulate was taken by filtration. The filtrate was vacuum-dried at 25°C to isolate 9.0 parts of crumb of the modified hydrogenated block copolymer [E₁].

FT-IR spectra for the modified hydrogenated block copolymer [E₁] were measured. A new absorption band attributed to a Si-OCH₃ group was observed at 1090 cm⁻¹ and new absorption bands attributed to a Si-CH₂ group were observed at 825 cm⁻¹ and 739 cm⁻¹, i.e. bands were observed at areas other than the absorption bands attributed to the Si-OCH₃ group and the Si-CH₂ group of vinyltrimethoxysilane (1075 cm⁻¹, 808 cm⁻¹, and 766 cm⁻¹).

Furthermore, the ¹H-NMR spectrum (in deuterated chloroform) of the modified hydrogenated block copolymer [E₁] was measured. A peak attributed to a proton of a methoxy group was observed at 3.6 ppm, and it was confirmed from the peak area ratio that 1.8 parts of vinyltrimethoxysilane bound to 100 parts of the hydrogenated block copolymer [D₁].

### [Example 1] Production of resin composition [F₁]

100 parts of pellet of the modified hydrogenated block copolymer [E₁] obtained in Production Example 1 was mixed with 3 parts of triallyl isocyanurate, which was extruded using a T die-type film melt extruder (width of the T die: 300 mm) having a twin-screw kneader equipped with a 37 mmϕ screw, a cast roll (with an embossing pattern) and an extrusion sheeter equipped with a rubber nip roll and a sheet take-off device under a forming condition that a temperature of the molten resin was 200°C, a temperature of the T-die was 200°C, and a temperature of the casting roll was 80°C, to obtain films (thicknesses: 50, 100, 400 µm, and width: 230 mm) including a resin composition [F₁] prepared by blending triallyl isocyanurate into the modified hydrogenated block copolymer [E₁]. The resulting film of the resin composition [F₁] was wound on a roll and collected.

### (Crosslinkability of resin composition [F₁])

Gamma ray irradiation (a dose of irradiation: 100 kGy, KOGA ISOTOPE, Ltd.) was carried out in order to crosslink the film (thickness: 400 um) of the resin composition [F₁]. Test pieces with a width of 100 mm and a length of 200 mm were respectively cut out from the film of the resin composition [F₁] irradiated with gamma ray, and the film of the unirradiated resin composition [F₁], held in an oven at 260°C for 60 seconds, then the film not irradiated with gamma ray was molten but the film irradiated with gamma ray did not melt and maintained its shape, and it was confirmed that the heat resistance was increased by crosslinking.

### (Electrical property)

Using a hot press forming machine, films of the resin composition [F₁] were laminated and compressed at 150°C to prepare a sheet having a thickness of 3 mm. This sheet was irradiated with gamma ray in the same manner as described above, then a test piece was cut out from the sheet, and the dielectric constant and dielectric loss tangent at a frequency of 1 GHz were measured. The dielectric constant was 2.19, and the dielectric loss tangent was 0.0019, which were sufficiently low and good values.

### [Example 2] Production of resin laminate [G₁-(F₁/a₁)]

A film of the resin composition [F₁] (thickness: 400 µm) and a polyimide film [a₁] (product name: "Kapton (registered trademark) 200 H", thickness: 50 µm, manufactured by DU PONT-TORAY CO., LTD.) were laminated, and the laminate was cut into a size of 200 mm in length and 200 mm in width, which was vacuum-degassed using a vacuum laminator (PVL 0202S, manufactured by Nisshinbo Mechatronics Inc.) at a temperature of 120°C for 5 minutes, and then pressurized at a press-bonding pressure of 0.1 MPa for 1 minute to produce a resin laminate [G₁- (F₁/a₁) ] having a two-layer structure of resin composition [F₁] / polyimide film [a₁].

The resulting resin laminate [G₁-(F₁/a₁)] was in a state that the resin composition [F₁] and the polyimide film [a₁] were weakly adhered to each other with a peel strength of 2 N/cm or lower. This resin laminate [G₁-(F₁/a₁)] could be strongly adhered by further thermocompression bonding. Further, the laminate was strongly adhered to a copper foil, an aluminum foil, a stainless steel foil, a glass, an ITO-deposited glass, ceramics, etc. through the resin composition [F₁] by thermocompression bonding.

The resin laminate [G₁-(F_{1/}a₁)] obtained above was pressurized using the vacuum laminator at a temperature of 170°C under a press-bonding pressure of 0.1 MPa for 15 minutes. As a result of evaluating the adhesiveness of the resin composition [F₁] to the polyimide film [a₁] for the resulting resin laminate [G₁-(F₁/a₁)], the peel strength was 29 N/cm, and the adhesiveness was rated as "Good".

### [Examples 3 and 4] Production of resin laminates [G₂-(F₁/a₂)] and [G₃-(F₁/a₃)]

Resin laminates [G₂-(F₁/a₂)] and [G₃-(F₁/a₃)] were produced in the same manner as Example 2 except that a polyimide film [a₂] (product name: "Upilex (registered trademark) -50S", thickness: 50 µm, manufactured by Ube Industries, Ltd.) or a polyimide film [a₃] (product name: "APICAL (registered trademark) 50AH", thickness of 50 µm, manufactured by KANEKA CORPORATION) was used instead of the polyimide film [a₁].

As a result of evaluating the adhesiveness with the resin composition [F₁] for the resulting resin laminates [G₂-(F₁/a₂)] and [G₃-(F₁/a₃)], the peel strengths were 28 N/cm and 25 N/cm respectively, and both of them were rated as "Good".

### [Comparative Examples 1 to 4]

Resin laminates [F₁/b], [F₁/c], [F₁/d] and [F₁/e] were prepared in the same manner as Example 2 except that (Comparative Example 1) a polyethylene terephthalate film [b] (product name: "Lumirror (registered trademark) S10", thickness: 50 um, manufactured by Toray Industries, Inc.), (Comparative Example 2) a polyphenylene sulfide film [c] (product name: "Torelina (registered Trademark) 3030", thickness: 50 um, manufactured by Toray Industries, Inc.), (Comparative Example 3) a polycarbonate film [d] (product name "Panlite (registered trademark) PC-2151", thickness: 200 µm, manufactured by Teijin Limited) or (Comparative Example 4) a polyethersulfone film [e] (product name: "SUMILITE (registered trademark) FS-1300", thickness: 100 um, manufactured by Sumitomo Bakelite Company Limited) was used respectively instead of the polyimide film [a₁]. As a result of evaluating the adhesiveness of the resin composition [F₁] to each resin film for the resulting resin laminates [F₁/b], [F₁/c], [F₁/d] and [F₁/e], all peel strengths were 2 N/cm or lower, and all of the resin films were rated as "Insufficient".

### [Example 5] Production of resin laminated copper foil [H₁-(a₁/F₁/Cu)]

The same polyimide film [a₁] as used in Example 2 / resin composition [F₁] film (thickness: 50um) produced in Example 1 / copper foil (product name: "FV-WS", thickness: 18 µm, maximum height roughness (Rz) : 1.5 um, manufactured by FURUKAWA ELECTRIC CO. , LTD.) were laminated in this order. This laminate was cut into a size of 200 mm in length and 200 mm in width, vacuum-degassed using a vacuum laminator at a temperature of 170°C for 5 minutes, and then pressurized under a press-bonding pressure of 0.1 MPa for 15 minutes to prepare a resin laminated copper foil [H₁-(a₁/F₁/Cu)].

### (Evaluation of adhesiveness)

As a result of evaluating the adhesiveness of the resin composition [F₁] to the copper foil for the resin laminated copper foil [H₁-(a₁/F₁/Cu)], the peel strength between the resin composition [F₁] and the copper foil was 18 N/cm, which was rated as "Good".

### (Evaluation of heat resistance)

The resin laminated copper foil [H₁-(a₁/F₁/Cu)] was irradiated with gamma ray (a dose of irradiation: 100 kGy) in the same manner as Example 1 in order to enhance heat resistance of the resin composition [F₁] layer in the resin laminated copper foil [H₁-(a₁/F₁/Cu)].

A test piece having a width of 100 mm and a length of 200 mm was cut out from the resin laminated copper foil [H₁-(a₁/F₁/Cu)] irradiated with gamma ray, held in an oven at 260°C for 60 seconds, then abnormality in appearance of the test piece was not observed, and it was confirmed that the heat resistance was high. Meanwhile, as a result of evaluating the resin laminated copper foil [H₁-(a₁/F₁/Cu)] not irradiated with gamma ray on the same condition, a part of the polyimide film was released from the copper foil in association with deformation of the resin composition [F₁] layer, indicating insufficient heat resistance.

### [Comparative Example 5] Production of resin laminated copper foil [H₂-(a₁/E₁/Cu)]

Except that the pellet of the modified hydrogenated block copolymer [E₁] obtained in Production Example 1 was used, the copolymer was extruded in the same manner as Example 1 to obtain a film (thickness: 50 um, width: 230 mm) including the modified hydrogenated block copolymer [E₁].

Subsequently, the polyimide film [a₁] / the modified hydrogenated block copolymer [E₁] film (thickness: 50 um) / the copper film were laminated in this order in the same manner as Example 2 except that the film of the modified hydrogenated block copolymer [E₁] was used instead of the resin composition [F₁]. This laminate was cut into a size of 200 mm in length and 200 mm in width, which was vacuum-degassed using a vacuum laminator at a temperature of 170°C for 5 minutes, and then pressurized under a press-bonding pressure of 0.1 MPa for 15 minutes to prepare a resin laminated copper foil [H₂-(a₁/E₁/Cu)].

### (Evaluation of adhesiveness)

As a result of evaluating the adhesiveness of the modified hydrogenated block copolymer [E₁] to the copper foil for the resin laminated copper foil [H₂-(a₁/E₁/Cu)], the peel strength between the modified hydrogenated block copolymer [E₁] and the copper foil was 20 N/cm, which was rated as "Good".

### (Evaluation of heat resistance)

The resin laminated copper foil [H₂-(a₁/E₁/Cu)] was irradiated with gamma ray (a dose of irradiation: 100 kGy) in the same manner as Example 1. A test piece having a width of 100 mm and a length of 200 mm was cut out from the resin laminated copper foil [H₂-(a₁/E_{1/}Cu)] irradiated with gamma ray, held in an oven at 260°C for 60 seconds, then a part of the polyimide film was released from the copper foil in association with deformation of the modified hydrogenated block copolymer [E₁] layer, indicating insufficient heat resistance.

### [Production Example 2] Production of modified hydrogenated block copolymer [E₂]

### (Block copolymer [C₂])

The polymerization reaction and the reaction-terminating operation were carried out in the same manner as Production Example 1, except that each of 30.0 parts of styrene, 60. 0 parts of isoprene and 10.0 parts of styrene was added in this order in three portions and the amount of the n-butyllithium (15% cyclohexane solution) was changed to 0.80 part in Production Example 1.

The resulting block copolymer [C₂] had a weight average molecular weight (Mw) of 51,200, a molecular weight distribution (Mw/Mn) of 1.04, and wA:wB was 40:60.

### (Hydrogenated block copolymer [D₂])

Subsequently, the polymer solution was hydrogenated in the same manner as Production Example 1. The hydrogenated block copolymer [D₂] after hydrogenation reaction had a weight average molecular weight (Mw) of 54,200 and a molecular weight distribution (Mw/Mn) of 1.06.

After completion of the hydrogenation reaction, an antioxidant was added in the same manner as in Production Example 1, and then concentrated and dried to obtain 92 parts of pellet of the hydrogenated block copolymer [D₂]. The resulting pelletized hydrogenated block copolymer [D₂] had a weight average molecular weight (Mw) of 53,700, a molecular weight distribution (Mw/Mn) of 1.11 and a hydrogenation ratio of nearly 100%.

### (Modified hydrogenated block copolymer [E₂])

The resulting pellet of the hydrogenated block copolymer [D₂] was used to obtain 94 parts of pellet of the modified hydrogenated block copolymer [E₂] having an alkoxysilyl group in the same manner as Production Example 1.

The resulting modified hydrogenated block copolymer [E₂] was analyzed in the same manner as Production Example 1, and it was confirmed that 1.8 parts of vinyltrimethoxysilane bound to 100 parts of the hydrogenated block copolymer [D₂].

### [Example 6] Production of resin composition [F₂]

A film (thickness: 50, 100, and 400 µm, width: 230 mm) including a resin composition [F₂] prepared by blending 10 parts of triallyl isocyanate into 100 parts of the modified hydrogenated block copolymer [E₂] was formed in the same manner as Example 1 except that the pellet of the modified hydrogenated block copolymer [E₂] obtained in Production Example 2 was used instead of the modified hydrogenated block copolymer [E₁]. The resulting film of the resin composition [F₂] was wound on a roll and collected.

### (Crosslinkability of resin composition [F₂])

The film (thickness: 400 um) of the resin composition [F₂] was irradiated with gamma ray (a dose of irradiation: 100 kGy) in the same manner as Example 1. The film of the resin composition [F₂] irradiated with gamma ray was held in an oven at 260 °C for 60 seconds, then the film did not melt and maintained its shape, and it was confirmed that the heat resistance was high.

### (Electrical property)

A test piece was prepared in the same manner as Example 1 except that the film of the resin composition [F₂] was used instead of the resin composition [F₁], and the dielectric constant and the dielectric loss tangent at a frequency of 1 GHz were measured. The dielectric constant was 2.2, and the dielectric loss tangent was 0.0018, which were sufficiently low and good values.

### [Example 7] Production of resin laminate [G₄-(F₂/a₁)]

A resin laminate [G₄-(F₂/a₁)] having a two-layer structure of resin composition [F₂] / polyimide film [a₁] was prepared by press-bonding at 110°C in the same manner as Example 2 except that the film (thickness: 400 um) of the resin composition [F₂] was used instead of the film of the resin composition [F₁].

The resulting resin laminate [G₄-(F₂/a₁)] was in a state that the resin composition [F₂] and the polyimide film [a₁] were weakly adhered to each other with a peel strength of 2 N/cm or lower. This resin laminate [G₄-(F₂/a₁)] could be strongly adhered by further thermocompression bonding. Further, the laminate was strongly adhered to a copper foil, an aluminum foil, a stainless steel foil, a glass, an ITO-deposited glass, ceramics, etc. through the resin composition [F₂] by thermocompression bonding.

The resin laminate [G₄-(F₂/a₄)] obtained above was pressurized using a vacuum laminator at a temperature of 170 °C under a press-bonding pressure of 0.1 MPa for 15 minutes. As a result of evaluating the adhesiveness of the resin composition [F₂] to the polyimide film [a₁] for the resulting resin laminate [G₄-(F₂/a₁)], the peel strength was 32 N/cm, which was rated as "Good".

### [Example 8] Production of resin laminated copper foil [H₃-(Cu/F₂/a₁/F₂/Cu)]

The same polyimide film [a₁] as used in Example 5, a copper foil (thickness: 18 um, maximum height roughness Rz: 1.5 µm) and the film (thickness: 50 µm) of the resin composition [F₂] produced in Example 6 were laminated in an order of copper foil / resin composition [F₂] / polyimide film [a₁] / resin composition [F₂] / copper foil. This laminate was cut into a size of 200 mm in length and 200 mm in width, vacuum-degassed using a vacuum laminator at a temperature of 170°C for 5 minutes, and then pressurized under a press-bonding pressure of 0.1 MPa for 20 minutes to prepare a resin laminated copper foil [H₃-(Cu/F₂/a₁/F₂/Cu)] in which the copper foils were laminated on both sides of the polyimide film.

### (Evaluation of adhesiveness)

As a result of evaluating the adhesiveness of the resin composition [F₂] to the copper foil for the resin laminated copper foil [H₃-(Cu/F₂/a₁/F₂/Cu)], the peel strength between the resin composition [F₂] and the copper foil was 22 N/cm, which was rated as "Good".

### (Evaluation of heat resistance)

The resin laminated copper foil [H₃-(Cu/F₂/a₁/F₂/Cu)] was irradiated with gamma ray (a dose of irradiation: 100 kGy) in the same manner as Example 5. As a result of evaluating the heat resistance for the resin laminated copper foil [H₃-(Cu/F₂/a₁/F₂/Cu)] irradiated with gamma ray in the same manner as Example 5, abnormality in appearance of the test piece was not observed, and it was confirmed that the heat resistance was high.

Meanwhile, as a result of evaluating the resin laminated copper foil [H₃-(Cu/F₂/a₁/F₂/Cu)] not irradiated with gamma ray on the same condition, a part of the polyimide film was released from the copper foil in association with deformation of the resin composition [F₂] layer, indicating insufficient heat resistance.

From the results of Examples and Comparative Examples, the followings can be seen.

When irradiated with gamma ray which is high energy ray, the resin composition [F] prepared by blending a crosslinking aid into the modified hydrogenated block copolymer [E] according to one embodiment of the invention, crosslinks to obtain heat resistance at a temperature of 260°C, and the dielectric constant and the dielectric loss tangent are also small and good (Examples 1 and 6).

The resin composition [F] prepared by blending a crosslinking aid into the modified hydrogenated block copolymer [E] according to one embodiment of the invention shows strong adhesiveness to the polyimide-based resin film (Examples 2, 3, 4 and 7).

On the other hand, the resin composition [F] according to one embodiment of the invention has low adhesiveness to the polyethylene terephthalate film, the polyphenylene sulfide film, the polycarbonate film, and the polyethersulfone film (Comparative Examples 1, 2, 3 and 4).

The resin laminated copper foil in which the polyimide film and the copper foil are adhered to each other through the resin composition [F] prepared by blending a crosslinking aid into the modified hydrogenated block copolymer [E] according to one embodiment of the invention, is excellent in adhesiveness between the resin and the copper foil (Examples 5 and 8) . In addition, heat resistance at a temperature of 260°C is provided by irradiating the resin laminated copper foil with gamma ray (Examples 5 and 8).

The resin laminated copper foil in which the polyimide film and the copper foil are adhered to each other through only the modified hydrogenated block copolymer [E] without blending any crosslinking aid, is excellent in adhesiveness between the resin and the copper foil, but heat resistance at 260°C is not provided even by irradiation with gamma ray (Comparative Example 5).

### Industrial Applicability

Since the resin composition according to one embodiment of the invention is excellent in adhesiveness and electrical insulation to a polyimide-based resin film and a copper foil having a small surface roughness, and can also be crosslinked to provide solder heat resistance, it is useful for manufacturing a high density flexible printed board and the like.

## Claims

1. A resin composition comprising:
a modified hydrogenated block copolymer [E] prepared by introducing an alkoxysilyl group into a hydrogenated block copolymer [D],
and a crosslinking aid;
wherein the hydrogenated block copolymer [D] is obtained by hydrogenating 90% or more of carbon-carbon unsaturated bonds on a main chain and side chains and carbon-carbon unsaturated bonds on aromatic rings in a block copolymer [C] which includes at least two polymer blocks [A] mainly containing a structural unit derived from an aromatic vinyl compound and at least one polymer block [B] mainly containing a structural unit derived from an acyclic conjugated diene compound,
wherein a ratio of wA to wB (wA:wB) is 30: 70 to 60:40 when a weight fraction of all the polymer blocks [A] accounting for all the block copolymers is defined as wA and a weight fraction of all the polymer blocks [B] accounting for all the block copolymers is defined as wB.

2. The resin composition according to claim 1, wherein a content of the crosslinking aid is 0.1 to 15 parts by weight based on 100 parts by weight of the modified hydrogenated block copolymer [E].

3. A resin laminate prepared by laminating a layer including the resin composition according to claim 1 or 2 on at least one side of a polyimide-based resin film.

4. A resin laminated metallic foil prepared by laminating a metallic foil on at least one side of a polyimide-based resin film through the layer including the resin composition according to claim 1 or 2.

5. The resin laminated metallic foil according to claim 4, wherein a surface roughness of the metallic foil is 3.0 µm or lower at the maximum height roughness Rz.

## Patentansprüche

1. Eine Harzzusammensetzung umfassend:
ein modifiziertes hydriertes Blockcopolymer [E], hergestellt durch die Einführung einer Alkoxysilyl-Gruppe in ein hydriertes Blockcopolymer [D],
und eine Vernetzungshilfe;
wobei das hydrierte Blockcopolymer [D] durch Hydrierung von 90% oder mehr der ungesättigten Kohlenstoff-Kohlenstoff Bindungen an einer Hauptkette und an Seitenketten sowie der ungesättigten Kohlenstoff-Kohlenstoff Bindungen an aromatischen Ringen in einem Blockcopolymer [C] erhalten wird, das mindestens zwei Polymerblöcke [A], die hauptsächlich eine von einer aromatischen Vinylverbindung abgeleitete Struktureinheit enthalten, und mindestens einen Polymerblock [B], der hauptsächlich eine von einer azyklischen konjugierten Dienverbindung abgeleitete Struktureinheit enthält, einschließt,
wobei ein Verhältnis von wA zu wB (wA:wB) 30:70 bis 60:40 beträgt, wenn ein Gewichtsanteil aller Polymerblöcke [A], die alle Blockcopolymere ausmachen, als wA definiert ist und ein Gewichtsanteil aller Polymerblöcke [B], die alle Blockcopolymere ausmachen, als wB definiert ist.

2. Die Harzzusammensetzung nach Anspruch 1, wobei ein Gehalt an Vernetzungshilfe 0,1 bis 15 Gewichtsteile, bezogen auf 100 Gewichtsteile des modifizierten hydrierten Blockcopolymers [E], beträgt.

3. Ein Harzlaminat, hergestellt durch Laminieren einer Schicht, die die Harzzusammensetzung nach Anspruch 1 oder 2 einschließt, auf mindestens eine Seite eines Harzfilms auf Polyimidbasis.

4. Eine harzlaminierte Metallfolie, hergestellt durch Laminieren einer Metallfolie auf mindestens eine Seite eines Harzfilms auf Polyimidbasis durch die Schicht, die die Harzzusammensetzung nach Anspruch 1 oder 2 einschließt.

5. Die harzlaminierte Metallfolie nach Anspruch 4, wobei eine Oberflächenrauheit der Metallfolie 3,0 µm oder weniger bei der Maximalhöhen-Rauheit Rz beträgt.

## Revendications

1. Composition de résine comprenant :
un copolymère séquencé hydrogéné modifié [E] préparé par introduction d'un groupe alcoxysilyle dans un copolymère séquencé hydrogéné [D],
et un adjuvant de réticulation ;
dans laquelle le copolymère séquencé hydrogéné [D] est obtenu par hydrogénation de 90 % ou plus des liaisons carbone-carbone insaturées sur une chaîne principale et des chaînes latérales et des liaisons carbone-carbone insaturées sur des cycles aromatiques dans un copolymère séquencé [C] qui inclut au moins deux blocs de polymère [A] contenant principalement un motif structural dérivé d'un composé vinylique aromatique et d'au moins un bloc de polymère [B] contenant principalement un motif structural dérivé d'un composé diène conjugué acyclique,
dans laquelle un rapport de wA à wB (wA:wB) est de 30:70 à 60:40 lorsqu'une fraction en poids de l'ensemble des blocs de polymère [A] représentant l'ensemble des copolymères séquencés est définie par wA et une fraction en poids de l'ensemble des blocs de polymère [B] représentant l'ensemble des copolymères séquencés est définie par wB.

2. Composition de résine selon la revendication 1, dans laquelle une teneur de l'adjuvant de réticulation est de 0,1 à 15 parties en poids sur la base de 100 parties en poids du copolymère séquencé hydrogéné modifié [E].

3. Stratifié de résine préparé par laminage d'une couche incluant la composition de résine selon la revendication 1 ou 2 sur au moins un côté d'un film de résine à base de polyimide.

4. Feuille métallique laminée avec de la résine préparée par laminage d'une feuille métallique sur au moins un côté d'un film de résine à base de polyimide à travers la couche incluant la composition de résine selon la revendication 1 ou 2.

5. Feuille métallique laminée avec de la résine selon la revendication 4, dans laquelle une rugosité de surface de la feuille métallique est de 3,0 µm ou moins à la rugosité de hauteur maximale Rz.
